# EUROPEAN PATENT SPECIFICATION

(11) **EP 2 826 837 B1**
(45) Date of publication and mention of the grant of the patent: **11.09.2019**
(21) Application number: 14177131.1
(22) Date of filing: 15.07.2014
(51) Int. Cl.: C09K 11/06, H05B 33/10

(54) **Organic light emitting device**
Organische lichtemittierende Vorrichtung
Dispositif électroluminescent organique

(30) Priority: 15.07.2013 KR 20130083012
(43) Date of publication of application: 21.01.2015
(73) Proprietor: Samsung Display Co., Ltd., Gyeonggi-do (KR)
(72) Inventor: Park, Yun Jee, Gyeonggi-do (KR); Seo, Ji Hyun, Incheon (KR)
(74) Representative: Mounteney, Simon James

(56) References cited:
- WO-A1-2013/017192
- DE-A1-102010 048 497
- WANG QI ET AL: "Highly efficient single-emitting-layer white organic light-emitting diodes with reduced efficiency roll-off", APPLIED PHYSICS LETTERS, AMERICAN INSTITUTE OF PHYSICS, US, vol. 94, no. 10, 9 March 2009 (2009-03-09) , pages 103503-103503, XP012118367, ISSN: 0003-6951, DOI: 10.1063/1.3097028
- KUWABARA Y ET AL: "THERMALLY STABLE MULTILAYERED ORGANIC EL DEVICES USING NOVEL STARBURST MOLECULES, 4,4',4''-TRI(N-CARBAZOYL)TRIPHENYLAMINE (TCTA) AND 4,4',4''-TRIS(3-METHYLPHENYLPHENYLAMINO)TR IPHENYLAMINE (M-MTDATA), AS HOLE-TRANSPORT MATERIALS", ADVANCED MATERIALS, WILEY - V C H VERLAG GMBH & CO. KGAA, DE, vol. 6, no. 9, 1 September 1994 (1994-09-01), pages 677-679, XP001203489, ISSN: 0935-9648, DOI: 10.1002/ADMA.19940060913
- NOMURA M. ET AL: "Synthesis of thermally stable and hole-transporting amorphous molecule having four carbazole moieties", SYNTHETIC METALS, ELSEVIER SEQUOIA, LAUSANNE, CH, vol. 148, no. 2, 31 January 2005 (2005-01-31), pages 155-160, XP027758460, ISSN: 0379-6779 [retrieved on 2005-01-31]

## Description

### BACKGROUND

### 1. Field

Embodiments relate to an organic light emitting device.

### 2. Description of the Related Art

It is desirable to make monitors and televisions thin and lightweight. Accordingly, cathode ray tubes (CRT) have been replaced by liquid crystal displays (LCD). However, liquid crystal displays are non-emissive devices that must be provided with a separate backlight to display images, and may have disadvantages of a limited response time and limited viewing angle.

In this connection, organic light emitting diode (OLED) displays have been developed as a display device that has advantages such as a wide viewing angle, outstanding contrast, and a fast response time.

The organic light emitting device includes two electrodes facing each other and an organic layer interposed between the two electrodes. In the organic light emitting diode device, electrons injected from one electrode and holes injected from another electrode are combined with each other in an emission layer, thereby generating excitons, and energy is outputted from the excitons to thereby emit light. The organic light emitting device may be applicable to various fields including a display device and an illumination system.

US 2013/0056720 A1 relates to a compound for an organic optoelectronic device and an organic photoelectric device including the compound.

### SUMMARY

The present invention is defined in claim 1 and embodiments thereof are defined in dependent claims 2 to 10. Embodiments are directed to an organic light emitting device, including a first electrode and a second electrode facing each other, and an organic layer between the first electrode and the second electrode. The organic layer includes an assistance layer on the first electrode and an emission layer on the assistance layer, the assistance layer including a compound represented by Chemical Formula 1: 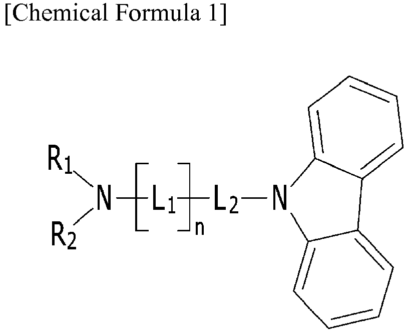
wherein, in Chemical Formula 1, L₁ and L₂ are independently selected from a C5 to C40 aryl group,
R₁ and R₂ are independently selected from a C5 to C40 aryl group or a C10 to C40 biaryl group, and
n is 0 or 1.

In the compound represented by Chemical Formula 1, n may preferably be 0, and R₁ or R₂ may preferably be condensed to an adjacent substituent or R₁ and R₂ may preferably form a ring.

The compound represented by Chemical Formula 1 may preferably include at least one selected from the compounds represented by Chemical Formula 1-1 to Chemical Formula 1-9:

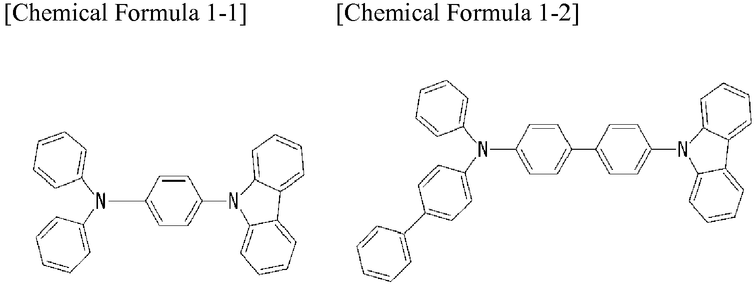

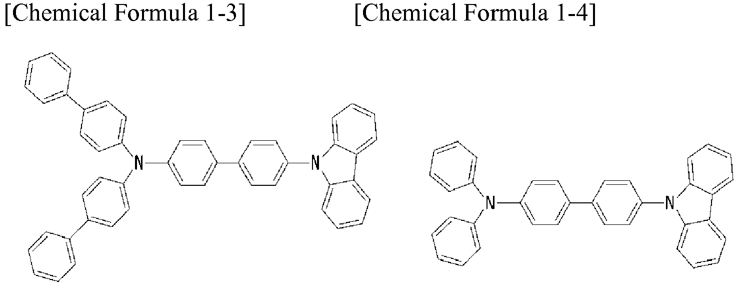

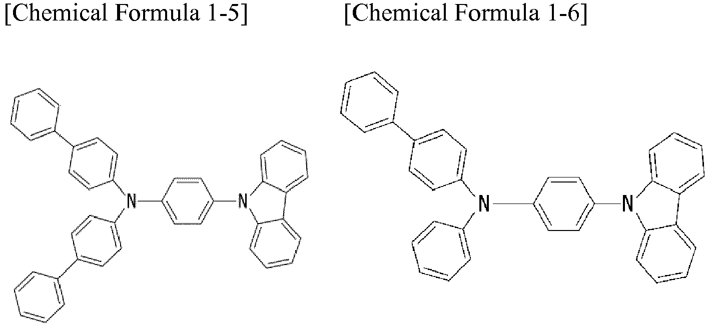

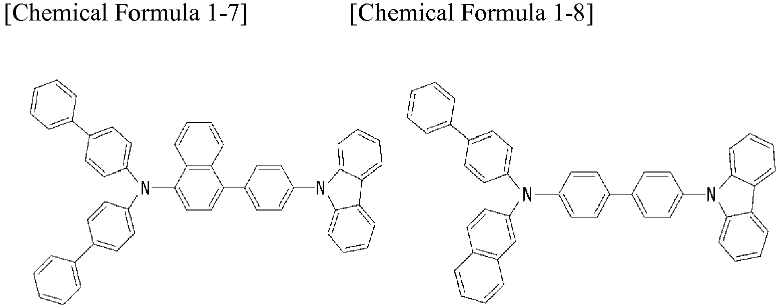

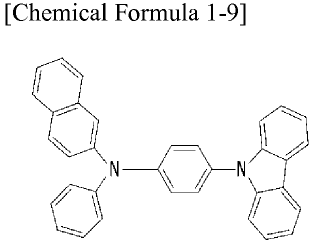

The emission layer includes a host material including a compound represented by Chemical Formula 2: 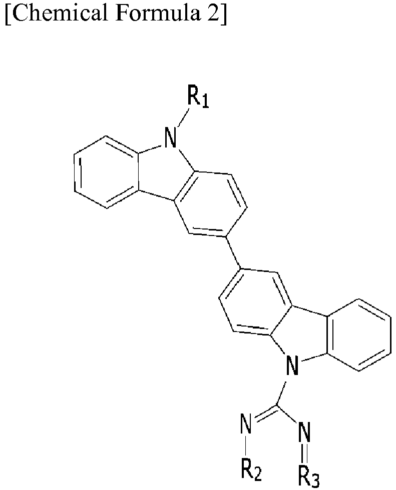 wherein, in Chemical Formula 2,
R₁ to R₂ are selected from a C5 to C40 aryl group or a C10 to C40 biaryl group,
R₃ is C(H)R₁ where R₁ is as defined above,
and R₂ and R₃ are condensed to form a ring which forms a diheteroaryl group with the N atoms that they are bound to.

R₁ to R₃ may preferably be condensed to an adjacent substituent or may preferably form a ring.

The compound represented by Chemical Formula 2 includes at least one selected from the compounds represented by Chemical Formula 2-1 to Chemical Formula 2-6:

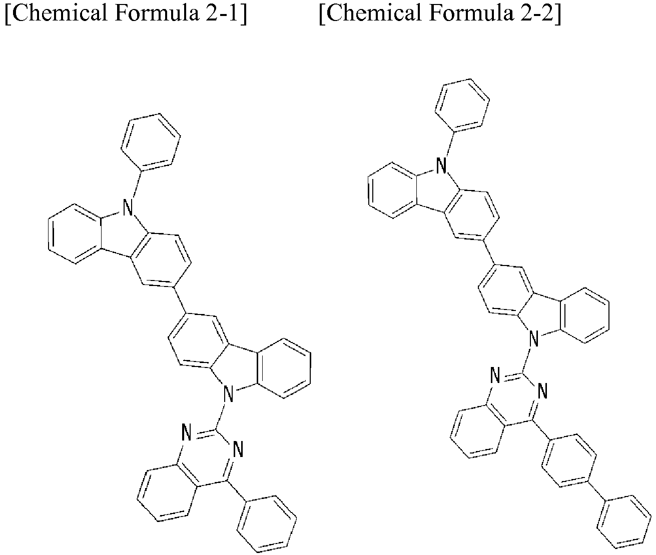

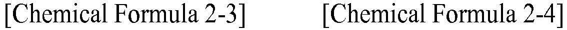

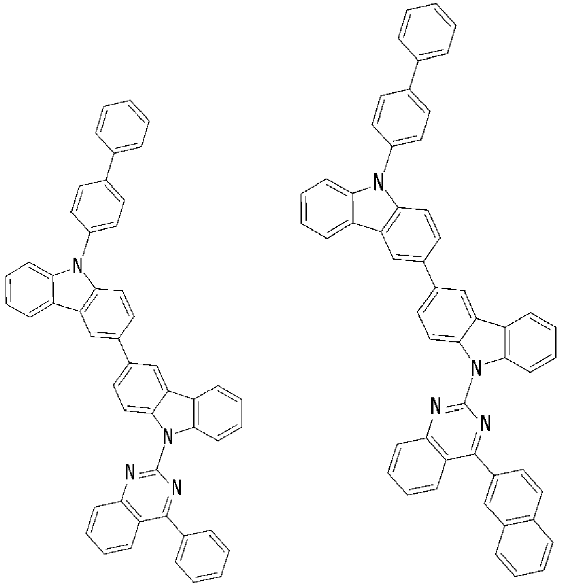

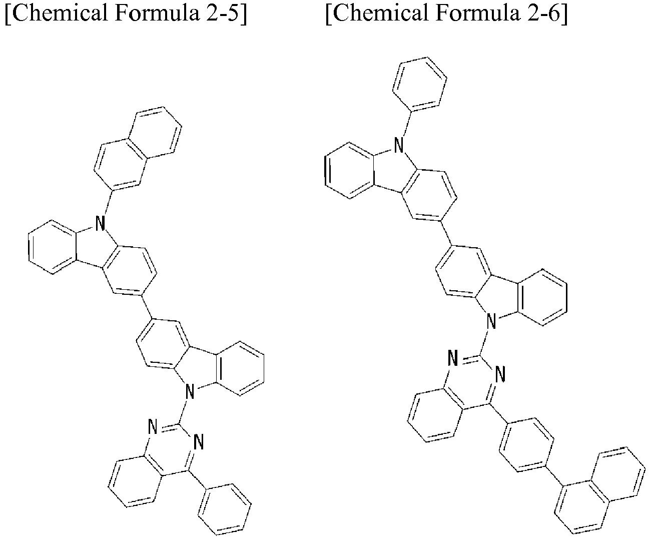

The emission layer may preferably further include a dopant material.

The dopant material may preferably include a red dopant material, a green dopant material, or a red dopant material.

The first electrode may preferably be an anode, and the second electrode may preferably be a cathode.

The organic layer may preferably include a hole injection layer (HIL) between the first electrode and the assistance layer, a hole transport layer (HTL) between the hole injection layer (HIL) and the assistance layer, and an electron transport layer (ETL) between the emission layer and the second electrode.

### BRIEF DESCRIPTION OF THE DRAWINGS

Features will become apparent to those of skill in the art by describing in detail exemplary embodiments with reference to the attached drawings in which:
FIG. 1 illustrates a view of an organic light emitting device according to an exemplary embodiment.
FIG. 2 illustrates a graph showing a light emitting degree and efficiency of an organic light emitting device according to Exemplary Embodiments 1 to 7 and an organic light emitting device according to a Comparative Example.

### DETAILED DESCRIPTION

Embodiments will now be described more fully hereinafter with reference to the accompanying drawings; however, they may preferably be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. In addition, it will also be understood that when a layer is referred to as being "between" two layers, it can be the only layer between the two layers, or one or more intervening layers may also be present. Like reference numerals refer to like elements throughout.

In the present exemplary embodiment, unless otherwise specified, "substituted" refers to a hydrogen atom of a compound substituted with a substituent selected from among halogen atoms (F, Br, Cl, or I), a hydroxyl group, an alkoxy group, a nitro group, a cyano group, an amino group, an azido group, an amidino group, a hydrazino group, a hydrazono group, a carbonyl group, a carbamyl group, a thiol group, an ester group, a carboxyl group or its salt, a sulfonic acid group or its salt, a phosphoric acid or its salt, an alkyl group, a C2-C16 alkenyl group, a C2-C16 alkynyl group, an aryl group, a C7-C13 arylalkyl group, a C1-C4 oxyalkyl group, a C1-C20 heteroalkyl group, a C3-C20 heteroaryl alkyl group, a cycloalkyl group, a C3-C15 cycloalkenyl group, a C6-C15 cycloalkynyl group, a heterocycloalkyl group, and combinations thereof.

Also, unless otherwise specified, "hetero" refers to containing one to three hetero atoms selected from among N, O, S, and P.

In the drawings, the thickness and/or relative thickness of the elements may be exaggerated in order to clarify embodiments. Also, the expressions related to positions such as "upper part", "lower part", or the like are relatively used for clarification, without limiting absolute positions among the elements.

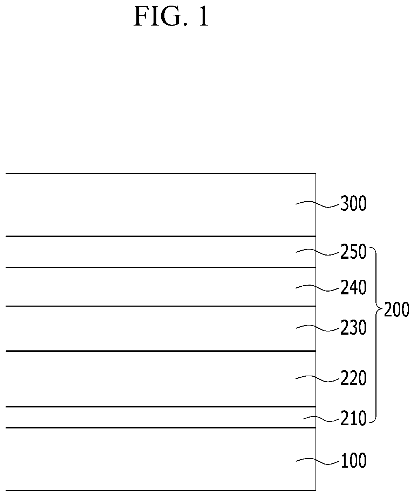

An organic light emitting device according to an exemplary embodiment will now be described with reference to FIG. 1.

FIG. 1 illustrates a view of an organic light emitting device according to an exemplary embodiment.

Referring to FIG. 1, an organic light emitting device according to the present exemplary embodiment includes a first electrode 100, a second electrode 300 facing the first electrode 100, and an organic layer 200 interposed between the first electrode 100 and the second electrode 300.

A substrate (not shown) may preferably be disposed at the first electrode 100 side or the second electrode 300 side. The substrate may preferably include glass, a polymer, or combinations thereof.

The first electrode 100 may preferably be an anode, and the second electrode 300 may preferably be a cathode. The first electrode 100 and the second electrode 300 may preferably be transparent or non-transparent electrodes. For example, the first electrode 100 and the second electrode 300 may preferably be a transparent electrode made of ITO (indium tin oxide), IZO (indium zinc oxide), or combinations thereof, or a non-transparent electrode made of aluminum (Al), silver (Ag), magnesium (Mg), or combinations thereof.

The organic layer 200 may preferably include a hole injection layer (HIL) 210, a hole transport layer (HTL) 220, an assistance layer 230, an emission layer 240, and an electron transport layer (ETL) 250 sequentially disposed on the first electrode 100.

The hole injection layer (HIL) 210 and the hole transport layer (HTL) 220 may preferably be disposed between the first electrode 100 and the emission layer 240, such that holes may be easily transmitted from the first electrode 100 to the emission layer 240.

The hole injection layer (HIL) 210 may preferably be formed of a hole injection material. For example, the hole injection material may preferably be a phthalocyanine compound such as copper phthalocyanine or the like, m-MTDATA (4,4',4"-tris(3-methylphenylphenylamino)triphenylamine), NPB (N,N'-di(1-naphthyl)-N,N'-diphenylbenzidine), TDATA, 2T-NATA, Pani/DBSA (polyaniline/dodecylbenzene sulfonic acid:polyaniline/dodecylbenzene sulfonic acid), PEDOT/PSS (poly(3,4-ethylene dioxythiophene)/poly(4-styrene sulfonate):poly(3,4-ethylene dioxythiophene)/poly(4-styrene sulfonate)), Pani/CSA (polyaniline/camphor sulfonic acid:polyaniline/camphor sulfonic acid), or Pani/PSS ((polyaniline)/poly(4-styrene sulfonate)).

The hole transport layer (HTL) 220 may preferably contain a hole transport material. For example, the hole transport material may preferably be a carbazole derivative such as N-phenylcarbazole, polyvinylcarbazole, or the like, and an amine derivative having an aromatic condensed ring such as NPB, N,N'-bis(3-methylphenyl)-N,N'-diphenyl-[1,1-biphenyl]-4,4'-diamine (TPD), tris(4-carbazoyl-9-ylphenyl)amine (TCTA), or the like.

The assistance layer 230 may preferably be disposed at the hole transport layer (HTL) 220 and the emission layer 240 to adjust a balance of the charges in the organic light emitting device thereby preventing roll-off generation.

The assistance layer 230 includes a compound represented by Chemical Formula 1 below. 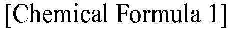 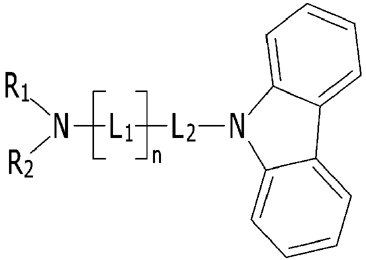 In Chemical Formula 1, L₁ and L₂ are independently selected from a C5 to C40 aryl group, and n is 0 or 1.

In a preferred embodiment of the present invention L₁ and L₂ may be independently selected from a C5 to C16 aryl group, preferably a C6 to C12 aryl group. In preferred embodiments of the present invention, L₁ and L₂ may be independently selected from the group of phenyl, naphthyl, anthracene and pyrene, more preferably phenyl and naphthyl. In an embodiment of the present invention, the above L₁ and L₂ groups are substituted with at least one of the substitute substituents defined above, preferably between 1 and 3 substituents.

When n is 0, L₂ and N are directly connected.

Further, R₁ and R₂ are independently selected from a C5 to C40 aryl group or a C10 to C40 biaryl group.

In a preferred embodiment of the present invention R₁ and R₂ may be independently selected from the group of a C5 to C16 aryl group and a C10 to C20 biaryl group, preferably a C6 to C12 aryl group and a C12 to C16 biaryl group. In a preferred embodiment of the present invention, R₁ and R₂ may be independently selected from the group of phenyl, naphthyl, anthracene, pyrene and biphenyl, more preferably biphenyl, phenyl and naphthyl.

R₁ and R₂ may preferably be condensed to the adjacent substituent or may preferably form a ring.

In an embodiment of the present invention, the above R₁ and R₂ groups are substituted with at least one of the substitute substituents defined above, preferably between 1 and 3 substituents.

As examples, a compound represented by Chemical Formula 1 may preferably be at least one selected from compounds represented by Chemical Formula 1-1 to Chemical Formula 1-9. The compound represented by Chemical Formula 1-1 to Chemical Formula 1-9 may preferably be independently used, at least two or more may preferably be mixed, or at least one may preferably be mixed with a different compound.

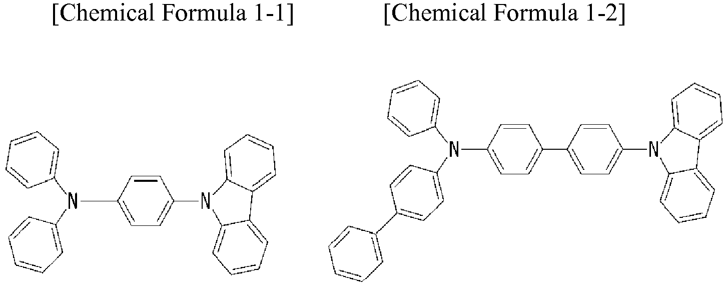

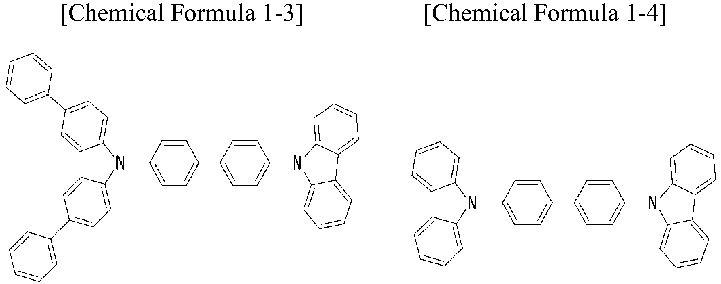

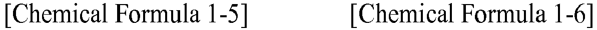

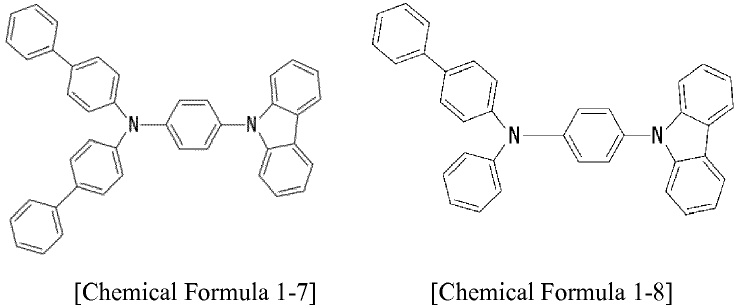

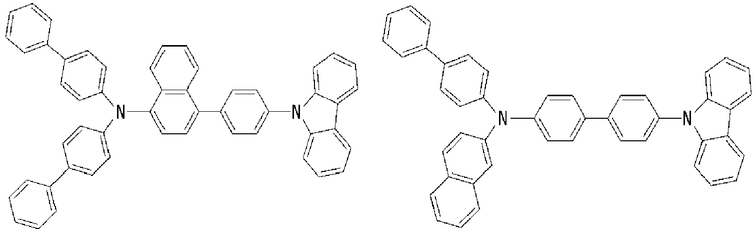

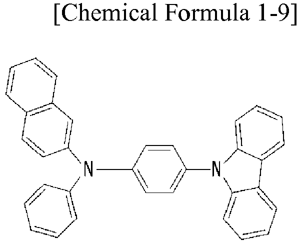

In an embodiment of the present invention, preferably the compound of chemical formula 1 makes up greater than 50% by weight of the assistance layer, preferably greater than 75% by weight, preferably between 85% and 100% of the assistance layer.

In an embodiment of the present invention, preferably the assistance layer is from 400Å to 1000Å, preferably 500Å to 900Å, more preferably 600Å to 800Å thick.

The emission layer 240 may preferably be made of a host material and a dopant. The dopant may preferably include a material that emits one among primary colors such as red, green, and blue.

The host material includes a compound represented by Chemical Formula 2. 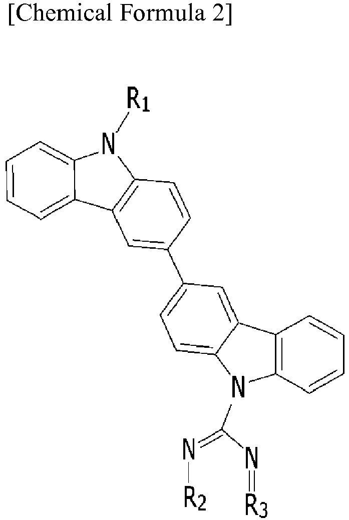
In Chemical Formula 2, R₁ to R₂ are selected from a C5 to C40 aryl group or a C10 to C40 biaryl group.
R₃ is C(H)R₁ where R₁ is as defined above and forms with R₂ a diheteroaryl group with the N atoms that they are bound.

Also, R₁ to R₃ may preferably be condensed to an adjacent substituent or may preferably form the ring.

In a preferred embodiment of the present invention R₁ is selected from the group of a C5 to C16 aryl group and a C10 to C20 biaryl group; preferably a C6 to C12 aryl group and a C12 to C16 biaryl group. In a preferred embodiment of the present invention, R₁ is selected from the group of phenyl, naphthyl, anthracene, pyrene and biphenyl, more preferably biphenyl, phenyl and naphthyl.

In the present invention, R₂ and R₃ form a diheteroaryl group with the N atoms that they are bound to. Preferably R₂ and R₃, the N atoms that they are bound to and the carbon atom linking the N atoms form a substituted or unsubstituted C2 to C40 diheteroaryl group, more preferably a substituted or unsubstituted C3 to C15 diheteroaryl group, more preferably a substituted or unsubstituted C4 to C10 a substituted or unsubstituted. For example, a substituted or unsubstituted pyrimidine group or a substituted or unsubstituted quinazoline group.

In an embodiment of the present invention, the above R₁ to R₃ groups in Chemical Formula 2 are substituted with at least one of the substitute substituents defined above, preferably between 1 and 3 substituents.

In an embodiment of the present invention the ring formed by R₂ and R₃ is substituted with at least one, preferably between 1 and 3 substituents independently selected from the group of a C5 to C40 aryl group, a C10 to C40 biaryl group, a C1 to C40 heteroaryl group, a C5 to C40 diarylamino group, a C2 to C40 diheteroarylamino group, and a C6 to C40 arylalkyl group, preferably a C5 to C16 aryl group, a C10 to C20 biaryl group, a C4 to C10 heteroaryl group, a C5 to C15 diarylamino group, a C4 to C10 diheteroarylamino group, and a C6 to C15 arylalkyl group, preferably a C6 to C12 aryl group and a C12 to C16 biaryl group. In a preferred embodiments of the present invention, the ring formed by R₂ and R₃ is substituted with at least one, preferably between 1 and 3, more preferably 1, substituent independently selected from the group of phenyl, naphthyl, anthracene, pyrene, biphenyl and a phenylnapthyl group, more preferably biphenyl, phenyl, phenylnapthyl group and naphthyl. In an embodiment of the present invention the ring formed by R₂ and R₃ is preferably substituted at a carbon adjacent to one of the N atoms, e.g. at the 4-position when the ring is quinazoline or the 4- or 6-position when the ring is pyrimidine.

For example, the compound represented by Chemical Formula 2 may preferably be at least one selected from compounds represented by Chemical Formula 2-1 to Chemical Formula 2-6. The compound represented by Chemical Formula 2-1 to Chemical Formula 2-6 may preferably be independently used, at least two or more may preferably be mixed, or at least one may preferably be mixed with a different compound.

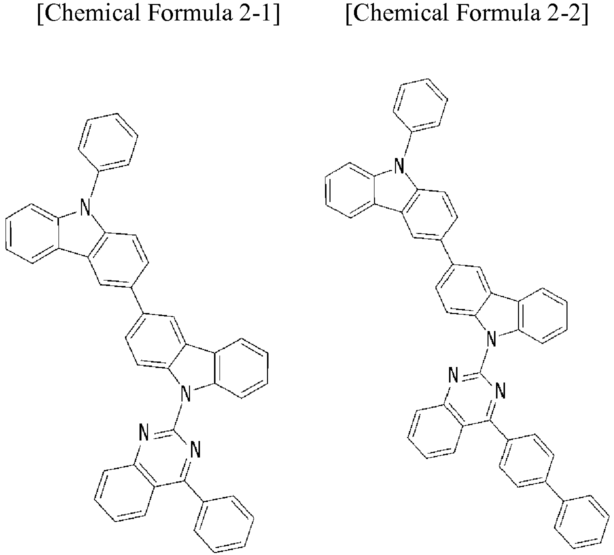

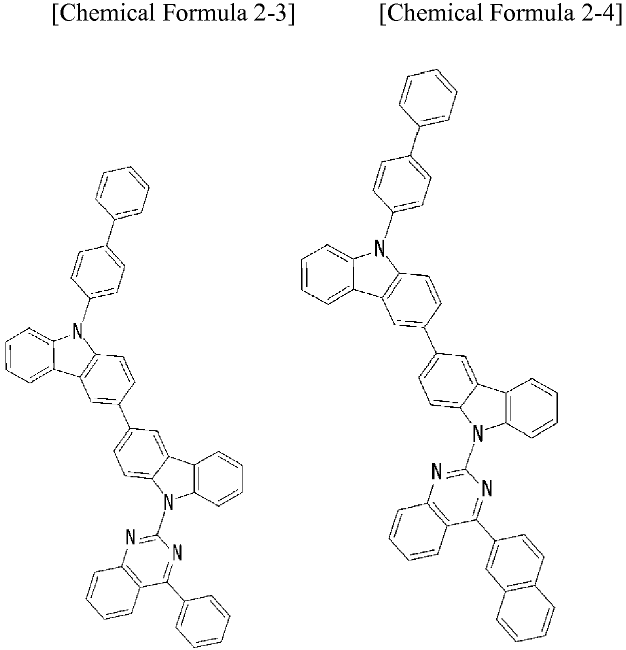

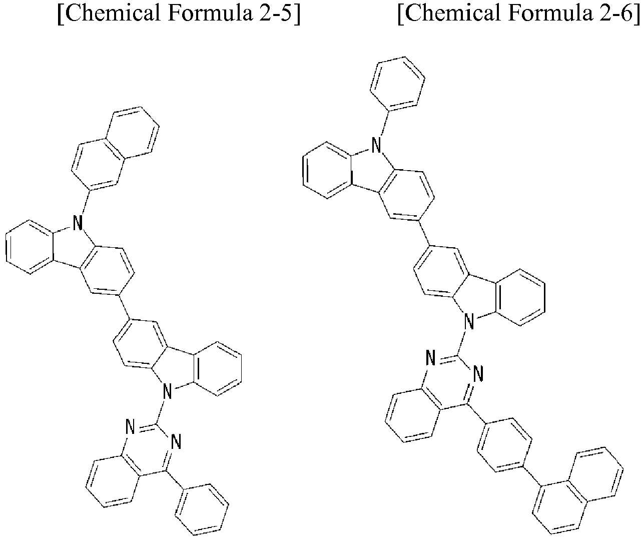

As examples, a red dopant may preferably include PtOEP, Ir(piq)₃, Btp₂Ir(acac), DCJTB, or the like.

As examples, a green dopant may preferably include Ir(ppy)₃(ppy=phenyl), Ir(ppy)₂(acac), Ir(mpyp)₃, C545T, or the like.

As examples, a blue dopant may preferably include F₂Irpic, (F₂ppy)2Ir(tmd), Ir(dfppz)₃, terfluorene, 4,4'-bis(4-diphenylaminostyryl)biphenyl (DPAVBi), 2,5,8,11-tetra-tert-butyl perylene (TBP), or the like.

For example, the emission layer 240 of the organic light emitting device includes the compound represented by Chemical Formula 2 as the host material, and may preferably be a red emission layer doped with the red dopant.

In an embodiment of the present invention the weight ratio of the host material and the dopant material is from 1.0:0.01 to 1.0:0.1, preferably from 1.0:0.02 to 1.0:0.06.

In an embodiment of the present invention, preferably the emission layer is from 100Å to 700Å, preferably 200Å to 600Å, more preferably 300Å to 500Å, thick.

The electron transport layer (ETL) 250 may preferably be disposed between the emission layer 240 and the second electrode 300. Thereby, electrons may be easily injected from the second electrode 300 to the emission layer 240. The electron transport layer (ETL) 250 may include an electron transport material. For example, the disclosed material may be a quinoline derivative such as aluminum tris(8-hydroxyquinoline) (Alq₃), TAZ, or BAlq.

The electron injection layer (EIL) may preferably be disposed between the electron transport layer (ETL) 250 and the second electrode 300 such that the electrons may be easily injected from the second electrode 300 to the emission layer 240. The electron injection layer (EIL) may preferably be made of an electron injection material, for example, lithium fluoride (LiF), lithium quinolate (Liq), oxadiazole, triazole, or triazine.

As described above, the assistance layer 230 made of the compound represented by Chemical Formula 1 may preferably be disposed between the hole transport layer (HTL) 220 and the emission layer 240. The compound represented by Chemical Formula 2 may preferably be used as the host material of the emission layer 240, thereby adjusting the balance of the elements in the organic light emitting device.

Accordingly, the generation of a roll-off phenomenon may be reduced. Further, the efficiency of the organic device may be improved, and the life-span may be increased.

The following Examples and Comparative Examples are provided in order to highlight characteristics of one or more embodiments, but it is to be understood that the Examples and Comparative Examples are not to be construed as limiting the scope of the embodiments,. Further, it is to be understood that the embodiments are not limited to the particular details described in the Examples and Comparative Examples.

### Exemplary Embodiment 1

ITO (indium tin oxide) was cut into a size of 50 mm x 50 mm x 0.5 mm and was subjected to an ultrasonic wave cleaning process for about ten minutes using isopropyl alcohol and pure water to form an anode.

2T-NATA (4,4',4"- tris[2-naphthyl(phenyl)amino]triphenylamine) having a thickness of 100 Å was vacuum-deposited on the anode to form a hole injection layer (HIL). NPB (N,N'-di(1-naphthyl)-N,N'-diphenylbenzidine) having a thickness of 1350 Å was vacuum-deposited on the hole injection layer (HIL) to form a hole transport layer (HTL).

The compound represented by Chemical Formula 1-3 and having a thickness of 700 Å was vacuum-deposited on the hole transport layer (HTL) to form an assistance layer. The compound represented by Chemical Formula 2-2, serving as a host material, and Ir(piq)₃ (Tris[1-phenylisoquinoline-C2,N]iridium(III), serving as a red phosphorescent dopant of a dopant material, were simultaneously subjected to vacuum deposition in a weight ratio of 1:0.04 to form an emission layer having a thickness of 400 Å on the assistance layer.

Alq₃ (Tris(8-hydroxyquinolinato)aluminum) was subjected to vacuum deposition to form an electron transport layer (ETL) with a thickness of 300 Å on the emission layer. Then, Al was subjected to vacuum deposition to form a cathode with a thickness of 1200 Å on the electron transport layer (ETL).

Thereby, the organic light emitting device is manufactured.

### Exemplary Embodiment 2

An organic light emitting diode device was manufactured by using substantially the same method as in Exemplary Embodiment 1, except for using the compound represented by Chemical Formula 1-1 as the assistance layer.

### Exemplary Embodiment 3

An organic light emitting diode device was manufactured by using substantially the same method as in Exemplary Embodiment 1, except for using the compound represented by Chemical Formula 1-2 as the assistance layer.

### Exemplary Embodiment 4

An organic light emitting diode device was manufactured by using substantially the same method as in Exemplary Embodiment 1, except for using the compound represented by Chemical Formula 1-4 as the assistance layer.

### Exemplary Embodiment 5

An organic light emitting diode device was manufactured by using substantially the same method as in Exemplary Embodiment 1, except for using the compound represented by Chemical Formula 1-5 as the assistance layer.

### Exemplary Embodiment 6

An organic light emitting diode device was manufactured by using substantially the same method as in Exemplary Embodiment 1, except for using the compound represented by Chemical Formula 2-1 as the host material of the emission layer.

### Exemplary Embodiment 7

An organic light emitting diode device was manufactured by using substantially the same method as in Exemplary Embodiment 2, except for using the compound represented by Chemical Formula 2-1 as the host material of the emission layer.

### Comparative Example

An organic light emitting diode device was manufactured by using substantially the same method as in Exemplary Embodiment 1, except for vacuum-depositing NPB with a thickness of 2100 Å to form the hole transport layer (HTL) and using CBP (4,4'-Bis(9-carbazolyl)-1,1'-biphenyl) as the host material of the emission layer without the assistance layer.

The driving voltage, the efficiency, and the life-span of the organic light emitting device according to Exemplary Embodiments 1 to 7 and the organic light emitting device according to the comparative example were measured. The measurement results are shown in Table 1.

**(Table 1)**

| | Assistance layer material | Host material | Driving voltage (V) | Current efficiency (Cd/A) | Life-span (T97, hours) |
|---|---|---|---|---|---|
| Comparative Example | - | CBP | 4.8 | 27.6 | 302 |
| Exemplary Embodiment 1 | Chemical Formula 1-3 | Chemical Formula 2-2 | 4.0 | 43.9 | 730 |
| Exemplary Embodiment 2 | Chemical Formula 1-1 | Chemical Formula 2-2 | 4.5 | 33.9 | 520 |
| Exemplary Embodiment 3 | Chemical Formula 1-2 | Chemical Formula 2-2 | 4.3 | 38.8 | 601 |
| Exemplary Embodiment 4 | Chemical Formula 1-4 | Chemical Formula 2-2 | 4.3 | 32.7 | 528 |
| Exemplary Embodiment 5 | Chemical Formula 1-5 | Chemical Formula 2-2 | 4.5 | 34.3 | 545 |
| Exemplary Embodiment 6 | Chemical Formula 1-3 | Chemical Formula 2-1 | 4.2 | 41.5 | 684 |
| Exemplary Embodiment 7 | Chemical Formula 1-1 | Chemical Formula 2-1 | 4.4 | 35.1 | 560 |

Referring to Table 1, in the organic light emitting device according to Exemplary Embodiments 1 to 7, the driving voltage is shown to be lower, and the current efficiency and the life-span are shown to be greater, compared with the organic light emitting device according to the Comparative Example.

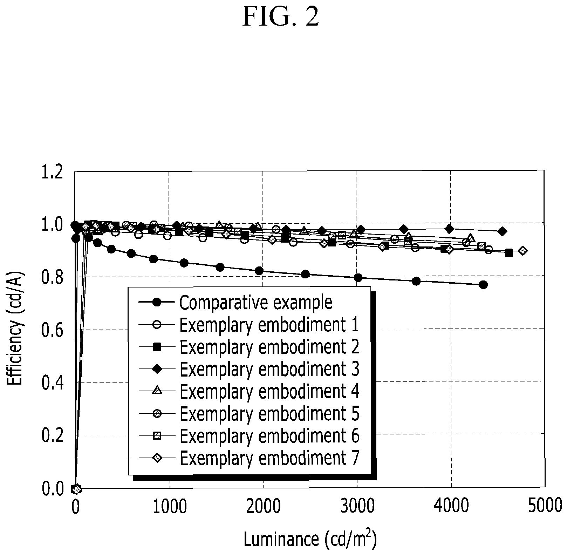

The efficiency according to a light emitting degree for the organic light emitting device according to Exemplary Embodiments 1 to 7 and the organic light emitting device according to the comparative example was measured. The measurement results are shown in FIG. 2.

FIG. 2 illustrates a graph showing a light emitting degree (luminance, in units of cd/m²) and efficiency (cd/A) of an organic light emitting device according to Exemplary Embodiments 1 to 7 and an organic light emitting device according to a Comparative Example.

Referring to FIG. 2, in the organic light emitting device according to the Comparative Example, compared with the organic light emitting device according to Exemplary Embodiments 1 to 7, as the light emitting degree was increased, the efficiency was decreased.

In the case of the organic light emitting device according to the Comparative Example, , the driving voltage was decreased by the hole injection layer (HIL) such that the initial efficiency was shown to be good. However, without being bound to any particular theory, it is believed that the charge balance in the elements was poor such that the roll-off phenomenon was generated, and thereby the efficiency was gradually reduced.

In contrast, by using the assistance layer in the organic light emitting devices according to Exemplary Embodiments 1 to 7, as the light emitting degree was increased, the reduction of the efficiency was slight such that it may be confirmed that the generation of the roll-off phenomenon may be reduced or avoided.

By way of summation and review, in an organic light emitting device, characteristics of a material forming the organic layer may largely affect electrical characteristics of the organic light emitting device.

Embodiments provide an organic light emitting device having high efficiency and a long life-span. According embodiments, by forming an assistance layer between the emission layer and the hole transport layer (HTL) including the compound represented by Chemical Formula 1 and the host in the emission layer including the compound represented by Chemical Formula 2, the efficiency of the organic light emitting device may be improved and the life-span may be increased.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope thereof as set forth in the following claims.

## Claims

1. An organic light emitting device, comprising:
a first electrode and a second electrode facing each other; and
an organic layer between the first electrode and the second electrode,
wherein the organic layer includes an assistance layer on the first electrode and an emission layer on the assistance layer, the assistance layer including a compound represented by Chemical Formula 1: 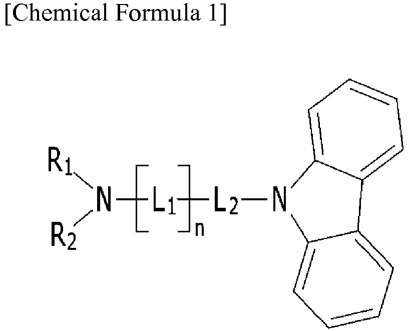
wherein, in Chemical Formula 1, L₁ and L₂ are independently selected from a C5 to C40 aryl group,
R₁ and R₂ are independently selected from a C5 to C40 aryl group or a C10 to C40 biaryl group, and
n is 0 or 1 and the emission layer includes a host material including a compound represented by Chemical Formula 2: 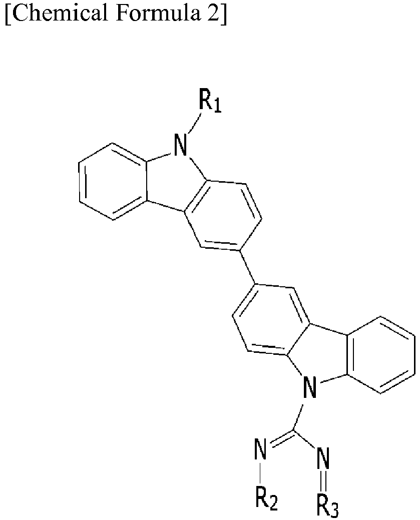
wherein, in Chemical Formula 2,
R₁ to R₂ are selected from a C5 to C40 aryl group or a C10 to C40 biaryl group;
R₃ is C(H)R₁ where R₁ is as defined above,
and where R₂ and R₃ are condensed to form a ring which forms a diheteroaryl group with the N atoms that they are bound to.

2. The organic light emitting device as claimed in claim 1, wherein in the compound represented by Chemical Formula 1,
n is 0, and, optionally,
R₁ or R₂ is condensed to an adjacent substituent.

3. The organic light emitting device as claimed in claim 1 or claim 2, wherein L₁ and L₂ are independently a C6 to C12 aryl group and R₁ and R₂ are independently a C6 to C12 aryl group or a C12 to C16 biaryl group.

4. The organic light emitting device as claimed in any of claims 1 to 3, wherein the compound represented by Chemical Formula 1 includes at least one selected from the compounds represented by Chemical Formula 1-1 to Chemical Formula 1-9:

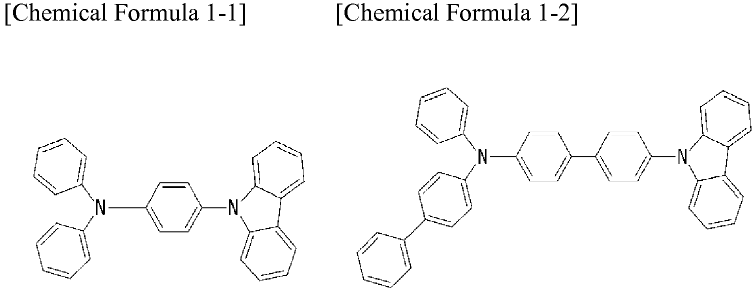

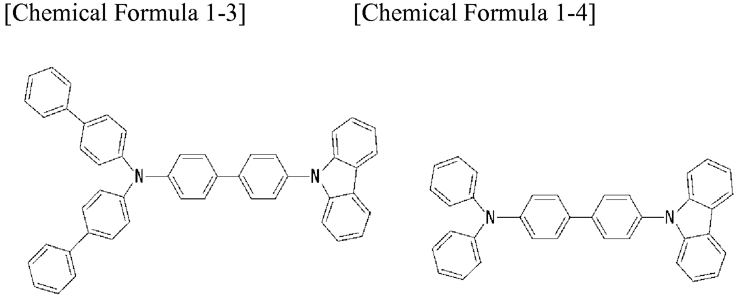

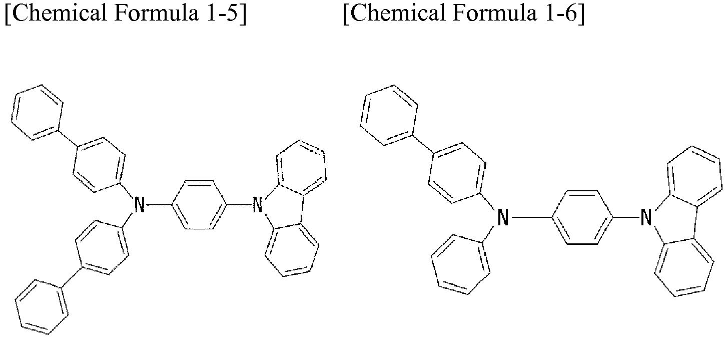

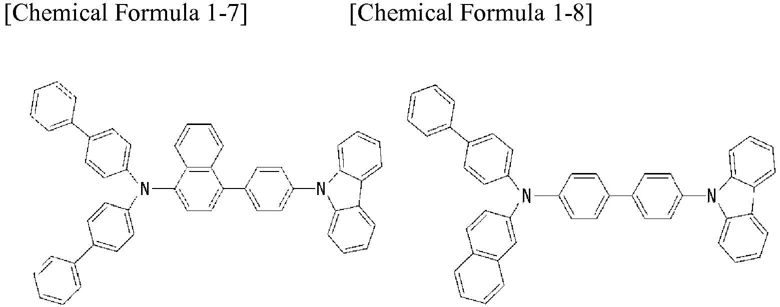

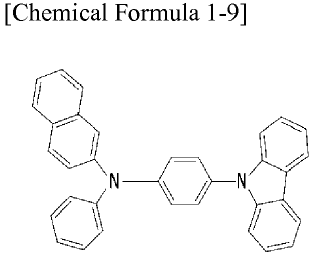

5. The organic light emitting device as claimed in any of claims 1 to 4, wherein the compound represented by Chemical Formula 2 includes at least one selected from the compounds represented by Chemical Formula 2-1 to Chemical Formula 2-6:

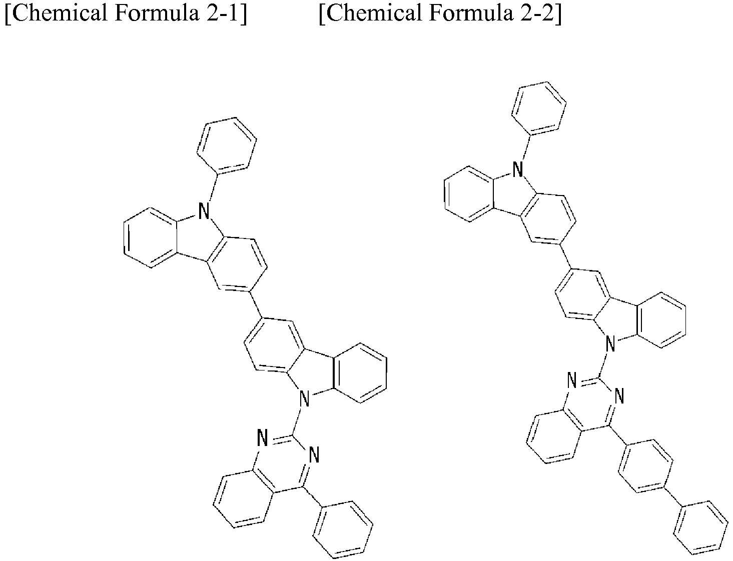

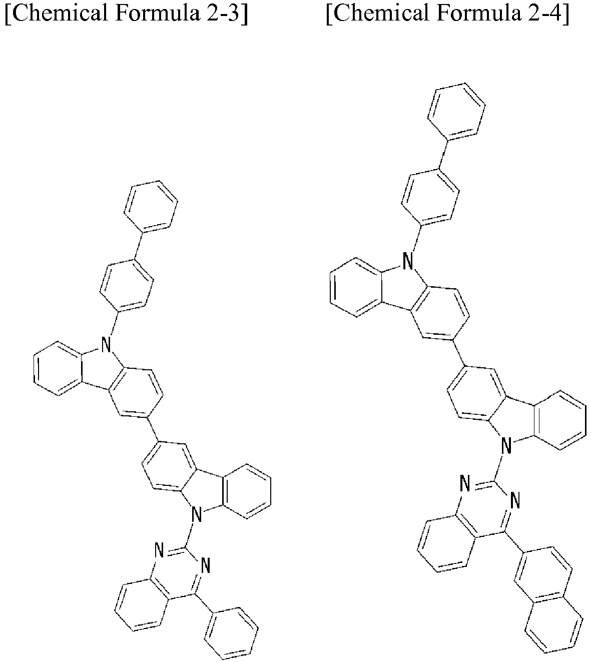

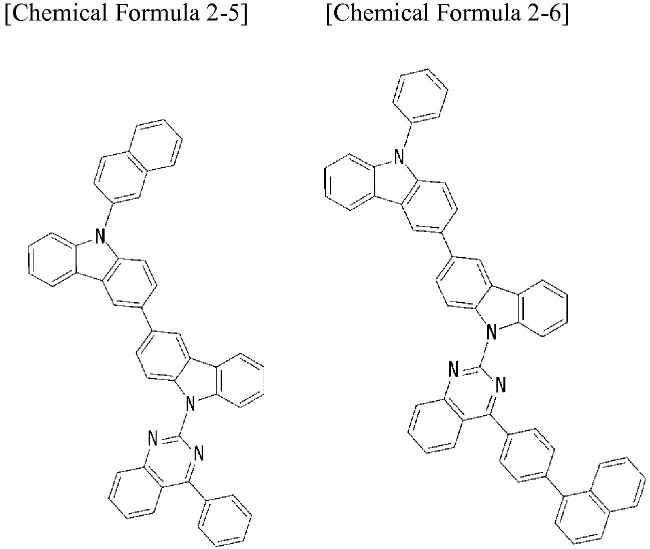

6. The organic light emitting device as claimed in any of claims 1 to 4, wherein the emission layer further includes a dopant material, optionally wherein the dopant material includes a red dopant material, a green dopant material, or a red dopant material.

7. The organic light emitting device as claimed in claim 6, wherein the weight ratio of the host material and the dopant material is from 1.0:0.01 to 1.0:0.1, preferably from 1.0:0.02 to 1.0:0.06.

8. The organic light emitting device as claimed in any of claims 1 to 7, wherein the emission layer is from 100Å to 700Å thick, preferably 200Å to 600Å, more preferably 300Å to 500Å; and/or the assistance layer is from 400Å to 1000Å thick, preferably 500Å to 900Å, more preferably 600Å to 800Å thick.

9. The organic light emitting device as claimed in any of claims 1 to 8, wherein the first electrode is an anode, and the second electrode is a cathode.

10. The organic light emitting device as claimed in any of claims 1 to 9, wherein the organic layer includes:
a hole injection layer (HIL) between the first electrode and the assistance layer;
a hole transport layer (HTL) between the hole injection layer (HIL) and the assistance layer; and
an electron transport layer (ETL) between the emission layer and the second electrode.

## Patentansprüche

1. Organische lichtemittierende Vorrichtung, umfassend:
eine erste Elektrode und eine zweite Elektrode, die einander zugewandt sind; und
eine organische Schicht zwischen der ersten Elektrode und der zweiten Elektrode,
wobei die organische Schicht eine Hilfsschicht auf der ersten Elektrode und eine Emissionsschicht auf der Hilfsschicht umfasst, wobei die Hilfsschicht eine durch die chemische Formel 1 dargestellte Verbindung umfasst: 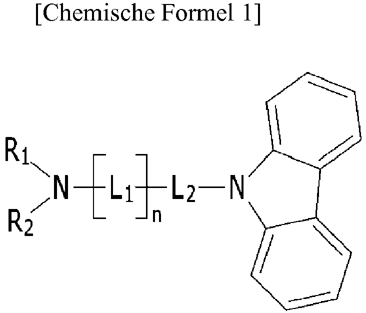
wobei in der chemischen Formel 1 L₁ und L₂ unabhängig voneinander aus einem C₅-bis C₄₀-Arylrest ausgewählt sind,
R₁ und R₂ unabhängig voneinander aus einem C₅- bis C₄₀-Arylrest oder einem C₁₀- bis C₄₀-Biarylrest ausgewählt sind und
n 0 oder 1 ist und die Emissionsschicht ein Hostmaterial, umfassend eine durch die chemische Formel 2 dargestellte Verbindung, umfasst: 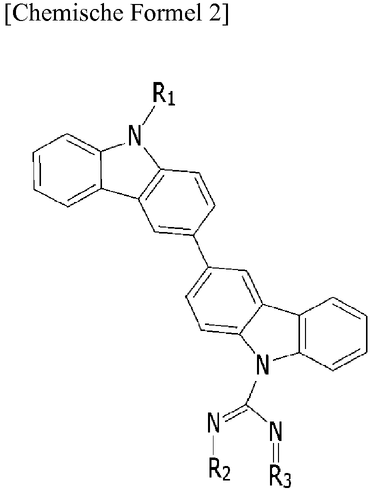
wobei in der chemischen Formel 2
R₁ bis R₂ aus einem C₅- bis C₄₀-Arylrest oder einem C₁₀- bis C₄₀-Biarylrest ausgewählt sind;
R₃ C(H)R₁ ist, wobei R₁ wie vorstehend definiert ist, und wobei R₂ und R₃ kondensiert sind, um einen Ring zu bilden, der mit den N-Atomen, an die sie gebunden sind, einen Diheteroarylrest bildet.

2. Organische lichtemittierende Vorrichtung nach Anspruch 1, wobei in der durch die chemische Formel 1 dargestellten Verbindung
n 0 ist und optional
R₁ oder R₂ an einen benachbarten Substituenten kondensiert ist.

3. Organische lichtemittierende Vorrichtung nach Anspruch 1 oder Anspruch 2, wobei L₁ und L₂ unabhängig voneinander ein C₆- bis C₁₂-Arylrest sind und R₁ und R₂ unabhängig voneinander ein C₆- bis C₁₂-Arylrest oder ein C₁₂- bis C₁₆-Biarylrest sind.

4. Organische lichtemittierende Vorrichtung nach einem der Ansprüche 1 bis 3, wobei die durch die chemische Formel 1 dargestellte Verbindung mindestens eine, ausgewählt aus den durch die chemische Formel 1-1 bis chemische Formel 1-9 dargestellten Verbindungen, umfasst:

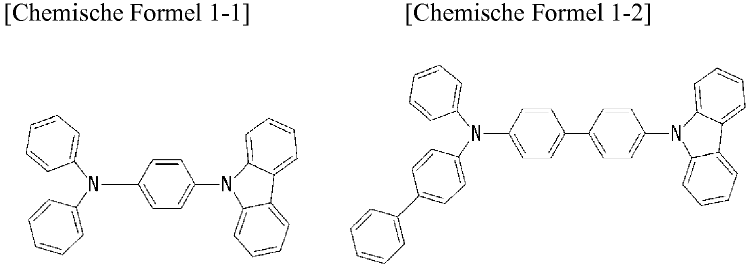

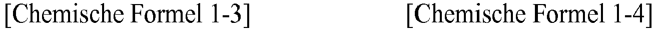

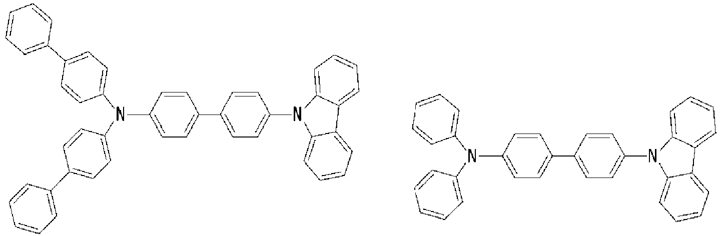

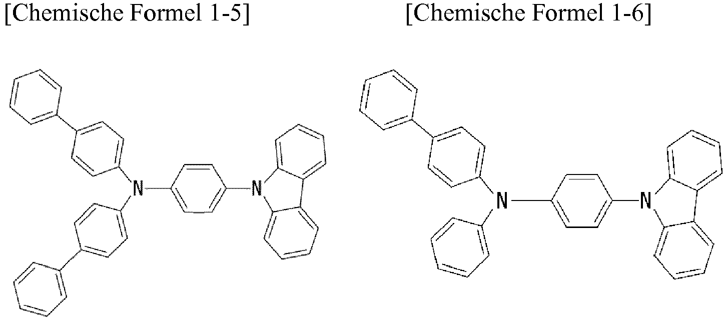

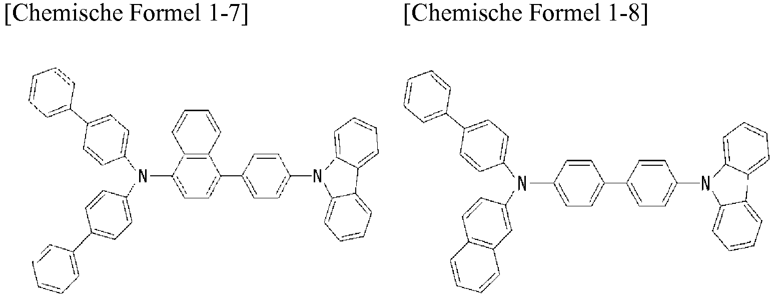

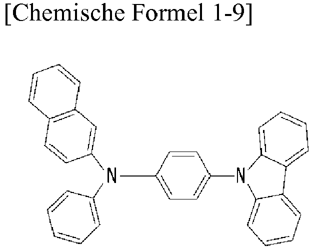

5. Organische lichtemittierende Vorrichtung nach einem der Ansprüche 1 bis 4, wobei die durch die chemische Formel 2 dargestellte Verbindung mindestens eine, ausgewählt aus den durch die chemische Formel 2-1 bis chemische Formel 2-6 dargestellten Verbindungen, umfasst:

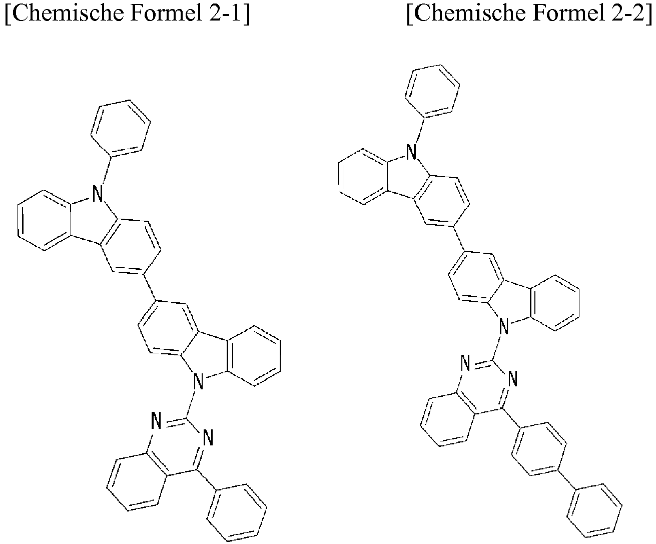

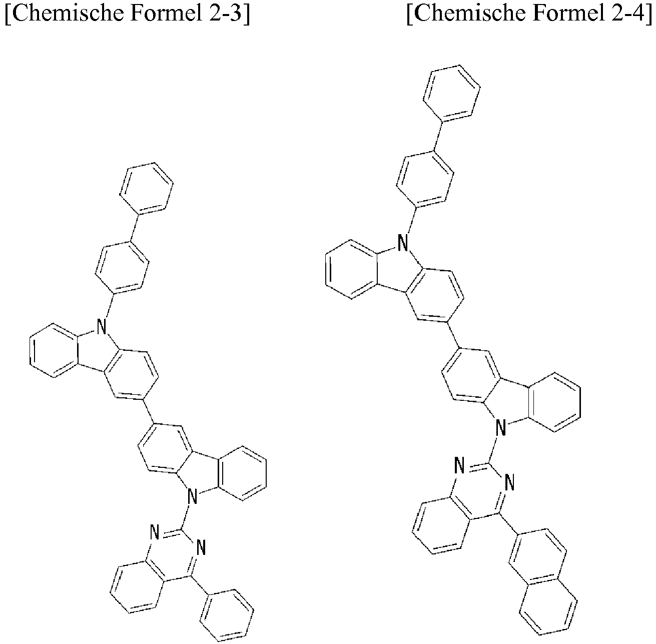

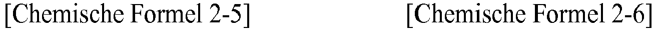

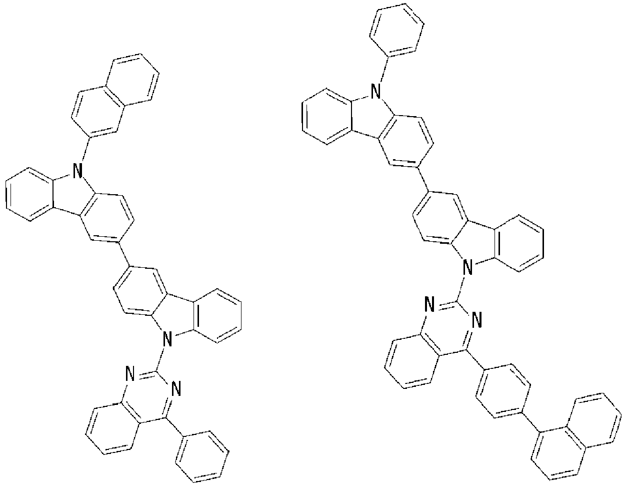

6. Organische lichtemittierende Vorrichtung nach einem der Ansprüche 1 bis 4, wobei die Emissionsschicht weiterhin ein Dotantenmaterial umfasst, wobei das Dotantenmaterial optional ein rotes Dotantenmaterial, ein grünes Dotantenmaterial oder ein rotes Dotantenmaterial umfasst.

7. Organische lichtemittierende Vorrichtung nach Anspruch 6, wobei das Gewichtsverhältnis des Hostmaterials und des Dotantenmaterials 1,0:0,01 bis 1,0:0,1, vorzugsweise 1,0:0,02 bis 1,0:0,06 beträgt.

8. Organische lichtemittierende Vorrichtung nach einem der Ansprüche 1 bis 7, wobei die Emissionsschicht 100 Å bis 700 Å, vorzugsweise 200 Å bis 600 Å, besonders bevorzugt 300 Å bis 500 Å, dick ist; und/oder die Hilfsschicht 400 Å bis 1000 Å dick, vorzugsweise 500 Å bis 900 Å, besonders bevorzugt 600 Å bis 800 Å dick, ist.

9. Organische lichtemittierende Vorrichtung nach einem der Ansprüche 1 bis 8, wobei die erste Elektrode eine Anode ist und die zweite Elektrode eine Kathode ist.

10. Organische lichtemittierende Vorrichtung nach einem der Ansprüche 1 bis 9, wobei die organische Schicht umfasst:
eine Lochinjektionsschicht *(hole injection layer* - HIL) zwischen der ersten Elektrode und der Hilfsschicht;
eine Lochtransportschicht (*hole transport layer* - HTL) zwischen der Lochinjektionsschicht (HIL) und der Hilfsschicht; und
eine Elektronentransportschicht (*electron transport layer* - ETL) zwischen der Emissionsschicht und der zweiten Elektrode.

## Revendications

1. Dispositif électroluminescent organique, comprenant :
une première électrode et une seconde électrode se faisant face l'une l'autre ; et
une couche organique entre la première électrode et la seconde électrode,
où la couche organique comprend une couche d'assistance sur la première électrode et une couche d'émission sur la couche d'assistance, la couche d'assistance comprenant un composé représenté par la formule chimique 1 : 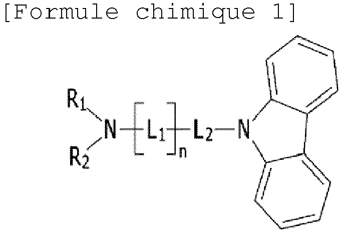
dans laquelle, dans la formule chimique 1, L₁ et L₂ sont choisis indépendamment parmi un groupe aryle en C5 à C40,
R₁ et R₂ sont choisis indépendamment parmi un groupe aryle en C5 à C40 ou un groupe biaryle en C10 à C40, et
n vaut 0 ou 1 et la couche d'émission comprend un matériau hôte représenté par la formule chimique 2 : 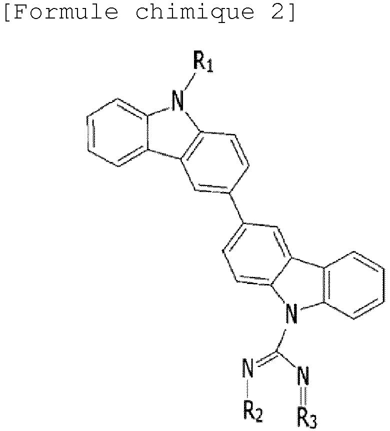
dans laquelle, dans la formule chimique 2,
R₁ à R₂ sont choisis parmi un groupe aryle en C5 à C40 ou un groupe biaryle en C10 à C40 ;
R₃ est un groupe C(H)R₁ où R₁ est tel que défini ci-dessus,
et où R₂ et R₃ sont condensés pour former un noyau qui forme un groupe dihétéroaryle avec les atomes N auxquels ils sont liés.

2. Dispositif électroluminescent organique selon la revendication 1, dans lequel dans le composé représenté par la formule chimique 1,
n vaut 0, et, éventuellement,
R₁ ou R₂ est condensé à un substituant adjacent.

3. Dispositif électroluminescent organique selon la revendication 1 ou la revendication 2, dans lequel L₁ et L₂ sont indépendamment un groupe aryle en C6 à C12 et R₁ et R₂ sont indépendamment un groupe aryle en C6 à C12 ou un groupe biaryle en C12 à C16.

4. Dispositif électroluminescent organique selon l'une quelconque des revendications 1 à 3, dans lequel le composé représenté par la formule chimique 1 comprend au moins l'un choisi parmi les composés représentés par la formule chimique 1-1 à la formule chimique 1-9 :

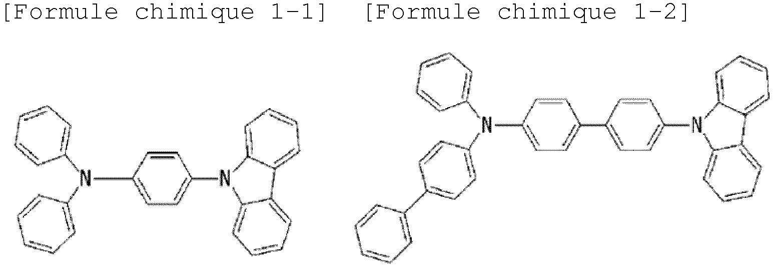

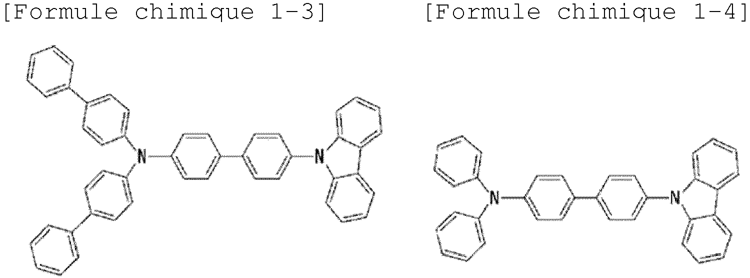

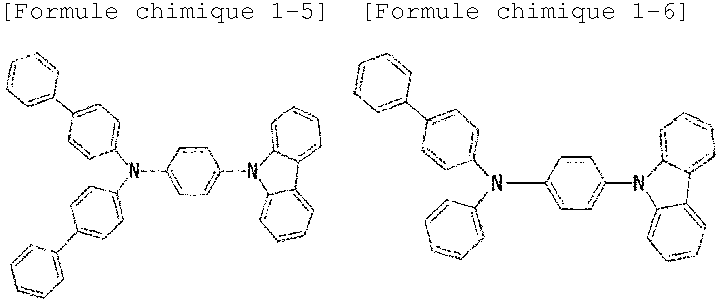

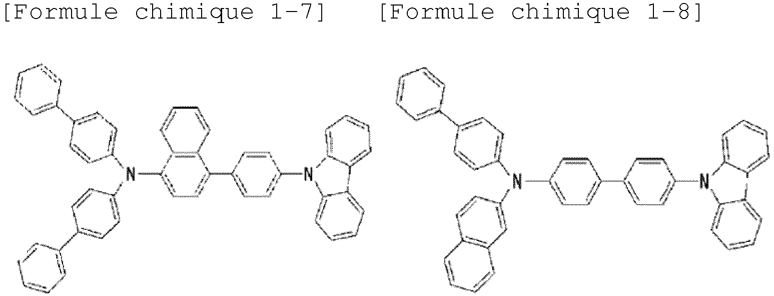

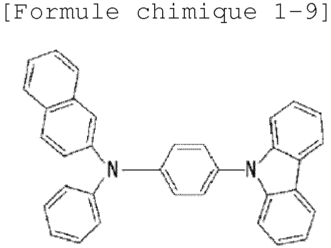

5. Dispositif électroluminescent organique selon l'une quelconque des revendications 1 à 4, dans lequel le composé représenté par la formule chimique 2 comprend au moins l'un choisi parmi les composés représentés par la formule chimique 2-1 à la formule chimique 2-6

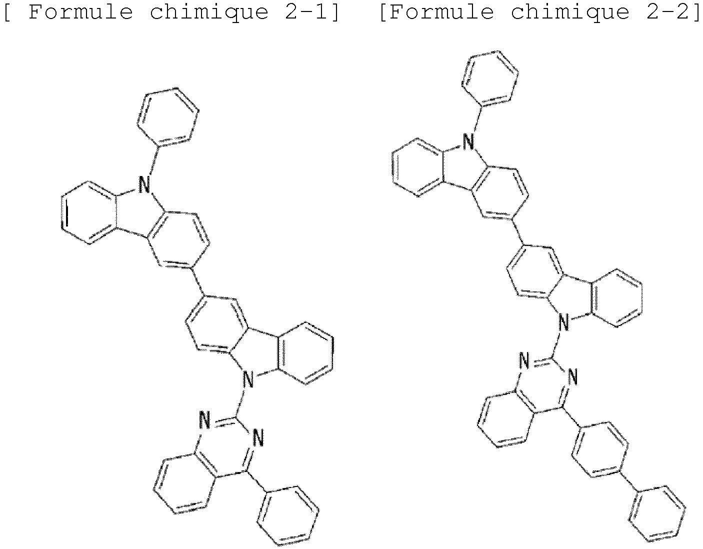

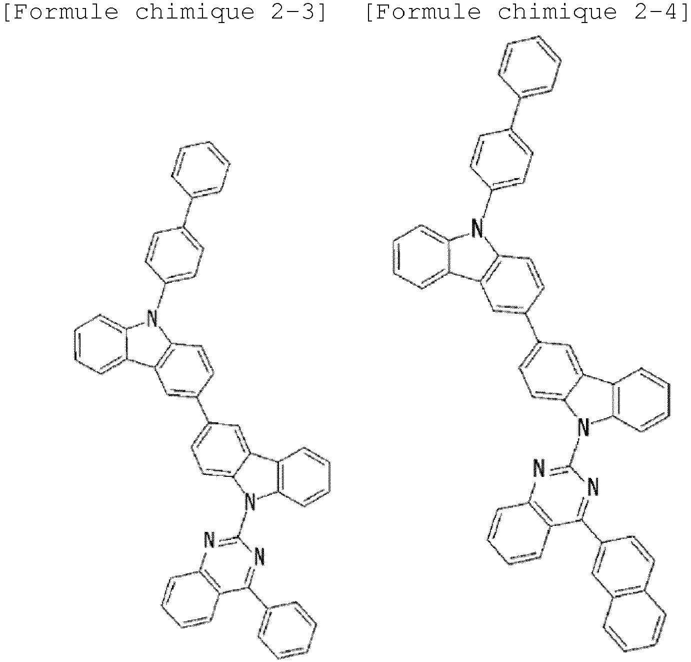

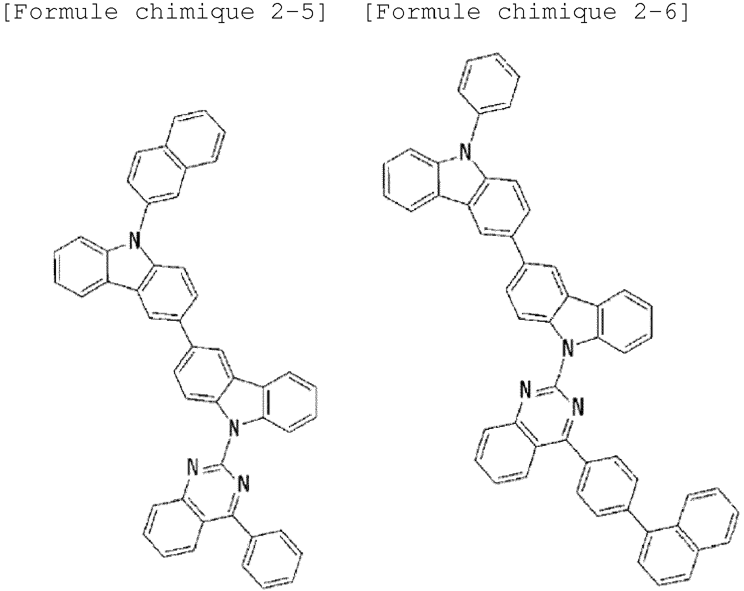

6. Dispositif électroluminescent organique selon l'une quelconque des revendications 1 à 4, dans lequel la couche d'émission comprend en outre un matériau dopant, éventuellement où le matériau dopant comprend un matériau dopant rouge, un matériau dopant vert ou un matériau dopant rouge.

7. Dispositif électroluminescent organique selon la revendication 6, dans lequel le rapport en poids du matériau hôte et du matériau dopant est de 1,0:0,01 à 1,0:0,1, de préférence de 1,0:0,02 à 1,0:0,06.

8. Dispositif électroluminescent organique selon l'une quelconque des revendications 1 à 7, dans lequel la couche d'émission a une épaisseur de 100 Å à 700 Å, de préférence de 200 Å à 600 Å, davantage de préférence de 300 Å à 500 Å ; et/ou la couche d'assistance a une épaisseur de 400 Å à 1000 Å, de préférence de 500 Å à 900 Å, davantage de préférence une épaisseur de 600 Å à 800 Å.

9. Dispositif électroluminescent organique selon l'une quelconque des revendications 1 à 8, dans lequel la première électrode est une anode et la seconde électrode est une cathode.

10. Dispositif électroluminescent organique selon l'une quelconque des revendications 1 à 9, dans lequel la couche organique comprend :
une couche d'injection de trous (HIL) entre la première électrode et la couche d'assistance ;
une couche de transport de trous (HTL) entre la couche d'injection de trous (HIL) et la couche d'assistance ; et
une couche de transport d'électrons (ETL) entre la couche d'émission et la seconde électrode.
